# EUROPÄISCHE PATENTSCHRIFT

(11) **EP 0 705 735 B1**
(45) Veröffentlichungstag und Bekanntmachung des Hinweises auf die Patenterteilung: **08.12.1999**
(21) Anmeldenummer: 95112916.2
(22) Anmeldetag: 17.08.1995
(51) Int. Cl.: B60R 11/02, H05K 5/02

(54) **Gehäuseträgeranordnung, insbesondere von Nutzfahrzeug-Elektronikgehäusen**
Support device for casings, in particular for casings of electronic devices in industrial vehicles
Dispositif de support pour boîtiers, notamment pour boîtiers de dispositifs électroniques dans véhicules utilitaires

(30) Priorität: 05.10.1994 DE 4435549
(43) Veröffentlichungstag der Anmeldung: 10.04.1996
(73) Patentinhaber: DaimlerChrysler AG, 70567 Stuttgart (DE)
(72) Erfinder: Kolb, Wolfgang, D-72622 Nürtingen-Reudern (DE); Lydorf, Karl-Ludwig, D-70565 Stuttgart (DE); Bochus, Helmut, D-76870 Kandel (DE); Wägerle, Georg, D-73092 Heiningen (DE); Wehleit, Gerd, D-71384 Weinstadt (DE); Zombor, Stefan, D-71067 Sindelfingen (DE)

(56) Entgegenhaltungen:
- DE-A- 2 314 343
- FR-A- 1 135 711
- FR-A- 1 591 065
- FR-A- 2 061 977
- GB-A- 2 203 328
- US-A- 5 130 891

## Beschreibung

Die Erfindung bezieht sich eine Gehäuseträgeranordnung nach dem Oberbegriff des Anspruchs 1. Eine solche Anordnung ist insbesondere zur Halterung von Gehäusen elektronischer Steuergeräte in einem Nutzfahrzeug verwendbar, das mit mehreren derartigen Steuergeräten zur Steuerung von diversen Aggregaten ausgerüstet ist. Die Gehäuse der erforderlichen Steuergeräte sind häufig unterschiedlich groß, wobei es bereits bekannt ist, die Gehäuse mittels Schraubverbindungen an einem jeweiligen Trägerteil zu befestigen.

Aus der Offenlegungsschrift DE 37 43 446 A1 ist ein Gerätesystem bekannt, bei dem Geräte mit ihrem Gehäuse aneinander über eine Rastbefestigung lösbar verbunden sind, wobei gleichzeitig elektrische Kontaktierungen vorgesehen sind. Die Rastverbindung beinhaltet dort die Anordnung eines schwenkbeweglichen Rasthakens an einem der beiden Gehäuse, der zum Trennen der Gehäuse freigebend betätigt werden muß.

In dem Gebrauchsmuster DE 78 08 240 U1 ist eine Kleingeräteanordnung mit mehreren Einzelgeräten beschrieben, die in einem gemeinsamen Trägergehäuse gehalten sind. Die Halterung kann durch eine Rastverbindung mit einer betätigbaren Federraste sowie einer an der Geräterückseite als Auswerfer angeordneten Blattfeder bestehen, so daß das verrastet eingeschobene Gerät nach Betätigen der Federraste ausgeworfen wird.

In den Offenlegungsschriften DE 36 32 470 A1 und DE 36 32 498 A1 sind Vorrichtungen zum Befestigen elektrischer Schaltgeräte in einem Geräteträger offenbart, bei denen das Schaltgerätegehäuse mit einer Seite gegen eine korrespondierende Seite des Trägers angesetzt und dort anschließend mittels einer Verriegelungs- oder Spannvorrichtung festgelegt wird, was einen entsprechenden Hebelmechanismus am Gerätegehäuse erfordert. Eine ähnliche Art der Befestigung eines Moduls an einer Gehäusewand wird in der Offenlegungsschrift DE 37 11 341 A1 beschrieben. Dort dient ein am Modul angelenkter, schwenkbeweglicher Hakenhebel zur Modulbefestigung.

In der Offenlegungsschrift EP 0 398 607 A1 ist ein Gehäuse zur rastenden Aufnahme einer Batterie offenbart. Die Batterie wird in eine einseitig offene Ausnehmung eingesteckt. Eine am inneren Ende der Aufnahme angebrachte Feder drückt die Batterie nach außen, während seitlich beidseits elektrische Federkontakte angeordnet sind und an einer Seite ein Rastmechanismus vorgesehen ist, der aus einer Rastausnehmung an der Batterie sowie einem am umgebenden Gehäuse angelenkten und mittels einer Feder in die Rastausnehmung gedrückten Rasthebel besteht. Rastausnehmung und Rasthebel sind so ausgelegt, daß die Batterie zunächst über ihre spätere Endlage hinaus gegen die Kraft der rückwärtigen Feder in die Ausnehmung gedrückt wird, bis der Rasthebel in die seitliche Rastausnehmung eingeschnappt, wonach die Batterie von der rückwärtigen Feder wieder etwas nach vorne geschoben wird, bis eine Rastnase an der Batterieausnehmung in einer zugehören Rastnut am Rasthebel aufgenommen ist und der Hebel die Batterie gegen ein weiteres Herausbewegen sichert. Um die Batterie zu entnehmen, ist diese wieder entgegen der Kraft der rückwärtigen Feder in die Ausnehmung zu drücken, bis die Rastverbindung freigegeben ist. Dann kann der Rasthebel entgegen seiner Federvorspannung in die Freigabeposition verschwenkt werden, wonach die Batterie herausnehmbar ist.

Aus der Patentschrift US 5 230 016 ist eine Halterung für ein Elektronikgehäuse, insbesondere ein Telefonhörergehäuse, bekannt, bei der das Elektronikgehäuse in eine einseitig offene Ausnehmung der Halterung eingesteckt wird. Eine am hinteren, inneren Ende der Halterung angebrachte Feder drückt das aufgenommene Elektronikgehäuse nach außen, während an einer Seite der Halterung ein Rasthebel vorgesehen ist, der unter Federvorspannung in eine Rastausnehmung des aufgenommenen Elektronikgehäuses eingreift und letzteres gegen ein Herausbewegen sichert. Um das Elektronikgehäuse zu entnehmen, ist der Rasthebel entgegen seiner Federvorspannung in eine Freigabeposition zu verschwenken, wonach das Elektronikgehäuse von der vorgespannten Feder wenigstens teilweise aus der Halterung herausbewegt und anschließend vom Benutzer entnommen werden kann.

Bei sämtlichen, oben angegebenen, bekannten Gehäuseträgeranordnungen ist folglich die Handhabung des Gehäusekörpers allein nicht ausreichend, um das Gehäuse vom Träger zu demontieren. Vielmehr ist hierzu jeweils zusätzlich ein separates Element zu betätigen. Außerdem sind häufig eigenständige, am Träger anzubringende Halteteile vorgesehen.

Aus der Offenlegungsschrift DT 2 314 343 ist eine Anordnung bekannt, bei der eine Schublade in ein Aufnahmegehäuse gegen den Druck einer in letzterem angeordneten Feder eingeschoben und durch Zusammenwirken der Rastelementpaare rastend befestigbar ist. Die Schublade weist ein Bedienungsteil auf, das um eine Schubladenquerachse gekippt werden kann, wobei das Bedienungsteil durch diese Kippbewegung die jeweilige Rastnase aus ihrer Rastnasenaufnahme herausdrückt, wodurch die Verriegelung gelöst wird. Das Lösen der Verriegelung mittels dieser Kippbewegung soll verhindern, daß allein durch eine starke Druckkraft auf die Frontplatte, z.B. zur Betätigung von dort vorgesehenen Sensorkontakten, aufgrund einer daraus resultierenden, geringfugigen Rückwärtsbewegung der Schublade die Rastnasen aus ihren Rastnasenaufnahmen herausgedrückt werden und sich die Schublade anschließend aus dem Aufnahmegehäuse herausbewegt.

Aus der Patentschrift FR 2 061 977 ist eine gattungsgemäße Anordnung zur rastbaren Halterung eines Autoradios offenbart. Die Spannfedereinheit besteht dort aus seitlich am Autoradiogehäuse angebrachten, oval- bzw. U-förmigen Drahtfedern, die beim Einschieben des Autoradios in eine Trägeröffnung elastisch gegen die Oberkante der Trägeröffnung andrücken und bei vollständig eingeschobenem Autoradiogehäuse eine auf letzteres mit einer ersten Komponente in Steckrichtung und mit einer zweiten Komponente in dazu senkrecht nach unten weisender Richtung wirkende Federkraft ausüben. An der Gehäuseunterseite befindet sich eine Rastnase, die sich durch die nach unten wirkende Federkraft mit der Unterkante der Trägeröffnung verrastet. Zum Lösen des Gehäuses vom Träger wird das Gehäuse gegen die nach unten weisende Federkraftkomponente nach oben angehoben und anschließend entgegen der Steckrichtung aus der Trägeröffnung herausgezogen.

Aus der Patentschrift FR 1 591 065 ist es bekannt, ein Autoradiogehäuse über eine Verbindungsplatte an einem Träger anzubringen, wobei die Verbindungsplatte am Träger fixierbar ist und an gegenüberliegenden Seitenflanschen Schlitzaufnahmen für an den Gehäuseseiten angebrachte Rastbolzen aufweist. Rückseitig ist das Gehäuse an einem schockabsorbierend elastischen Flansch der Verbindungsplatte fixiert. Je nach Anordnung der Schlitzaufnahmen kann das Gehäuse in oder entgegen der Steckrichtung gegen die elastische Kraft des rückseitigen Verbindungsplattenflansches mit seinen Rastbolzen aus den Steckaufnahmen der Verbindungsplatte herausbewegt werden, von denen es freikommt, wenn das Gehäuse anschließend senkrecht zur Steckrichtung wegbewegt wird.

Der Erfindung liegt als technisches Problem die Bereitstellung einer Gehäuseträgeranordnung der eingangs genannten Art zugrunde, bei welcher der Träger mit vergleichsweise geringem Konstruktionsaufwand gefertigt werden kann, das Anbringen und Lösen eines jeweiligen Gehäuses am Träger mit hohem Bedienungskomfort möglich ist und mehrere Gehäuse möglichst spielfrei und/oder sehr platzsparend am Träger angeordnet werden können.

Dieses Problem wird durch eine Gehäuseträgeranordnung mit den Merkmalen des Patentanspruchs 1 oder 2 gelöst. Diese Anordnungen sind mit außergewöhnlich hohem Bedienungskomfort allein durch Handhabung des Gehäuses am Träger nicht nur rastend montierbar, sondern auch wieder demontierbar. Letzteres erfolgt einfach durch Drücken des montierten Gehäuses in Steckrichtung gegen die Spannfeder, wodurch die jeweilige Rastnase in eine von ihrer zugehörigen Aufnahme freigegebene Position bewegt wird, und anschließendes Herausführen der Rastnase aus ihrer zugeordneten Aufnahme durch eine geringfügige Gehäusebewegung in zur Steckrichtung senkrechter Richtung. Das Lösen des Gehäuses aus der Rastverbindung mit dem Träger erfordert somit keine Betätigung eines weiteren, beweglichen Halterungselementes. Zudem ist zur Montage und Demontage keinerlei Werkzeug erforderlich. Befestigungsteile von Schraubverbindungen werden ebenso eingespart wie der Platzbedarf für bekannte Befestigungslaschen. Der Wegfall solcher weiterer Halterungselemente vereinfacht zudem den konstruktiven Aufwand. Diesbezüglich ist außerdem von Vorteil, daß keine separaten Elemente zur Gehäusefestlegung am Träger angebracht sein müssen und letzterer folglich als einstückiges Teil realisierbar ist. Auch an dem festzulegenden Gehäuse ist nur die Anbringung der einen oder mehreren Spannfedern erforderlich, während die Rastnasen und Rastaufnahmen bereits am Gehäuse bzw. am Träger angeformt sein können. Zur Montage und Demontage ist die Zugänglichkeit an der in Steckrichtung vorderen Seite ausreichend, da die Rastverbindung jeweils durch geeignete Bewegung des Gehäuses im wesentlichen parallel zur Steckrichtung sowie in geringem Maße in einer dazu senkrechten Richtung hergestellt und wieder gelöst werden kann. Die auf diese Weise realisierbare Gehäuseanbringung am Träger läßt sich in Verbindung mit der Wahl einer geeigneten Federkonstante für die Spannfedern sowie einer geeigneten, aufeinander abgestimmten Gestaltung der haltend zusammenwirkenden Teile sehr erschütterungsfest auslegen, so daß sie sich insbesondere auch zur Anbringung von Elektronikgehäusen an einem Träger in einem Nutzfahrzeug eignet, wo aufgrund von fahrbahnbedingten Erschütterungen eine hohe Stabilität der Gehäusehalterung am Träger gefordert ist, die z.B. Beschleunigungseffekten bis zum Vierfachen der Erdbeschleunigung sicher standhält.

Die Anordnung gemäß Anspruch 1 ermöglicht durch den zur Steckrichtung spitzwinkligen Verlauf der Rastnasenseitenfläche eine quer zur Steckrichtung klemmende und damit stabilisierende Verrastung der Rastnase in der zugeordneten Rastnasenaufnahme, deren zugehöriger Rand mit einer korrespondierenden Schrägung versehen ist. Mit dieser Maßnahme läßt sich einerseits die Rastnase bequem in die Aufnahme einführen und andererseits eine quer zur Steckrichtung unabhängig von Fertigungstoleranzen spielfreie Verrastung realisieren.

Bei der Anordnung nach Anspruch 2 können wahlweise mehrere Gehäuse unterschiedlicher Größe an einer Halteplatte festgelegt und/oder besonders raumsparend angeordnet werden. Dazu weist die Halteplatte Rastnasenaufnahmen für die Rastnasen der Gehäuse in bezüglich der Steckrichtung unterschiedlichen Tiefen und/oder Rastnasenaufnahmen auf, in denen jeweils zwei Rastnasen von auf gegenüberliegenden Halteplattenseiten aufsteckbaren Gehäusen aufgenommen werden können. So können beispielsweise die Steuergeräte für ein Nutzfahrzeug in zwei oder drei standardisierten Gehäusegrößen untergebracht sein und die jeweils bei einem bestimmten Fahrzeug vorhandenen Steuergeräte an einem einzigen, für alle Fahrzeuge gleichartigen Träger durch einfaches, rastendes Aufstecken festlegt werden, wobei jeweils ein Gehäuse an der Oberseite sowie eines an der Unterseite der Halteplatte gehalten werden kann. In Weiterbildung der Anordnung von Anspruch 2 beinhaltet diese gemäß Anspruch 3 den zur Steckrichtung spitzwinkligen Verlauf der wenigstens einen von den sich quer zur Steckrichtung gegenüberliegenden Rastnasenseitenflächen und der gegen diese zur Anlage kommenden Randseite der Rastnasenaufnahme entsprechend Anspruch 1.

In konstruktiv vorteilhafter Ausgestaltung der Erfindung sind gemäß Anspruch 4 die Spannfedern an der Gehäuserückwand befestigt, während die Rastnasen einstückig an der Gehäusevorderwand angeformt sind. Dadurch ist ein großer, die Gehäusehalterung am Träger stabilisierender Abstand der entsprechenden Befestigungspunkte parallel zur Steckrichtung gegeben.

Für ein schmalseitig an einer Trägerwand festzulegendes Gehäuse wird durch eine Weiterbildung der Erfindung nach Anspruch 5 erreicht, daß beim Anlegen der Spannfeder gegen den zugeordneten Anschlag sowohl die Spannkraft entgegen der Einsteckrichtung für die Sicherung der Verrastung als auch eine Sicherung der Gehäuselage senkrecht zur Schmalseitenfläche an der Gehäuserückseite bereitgestellt wird, während diese Lagesicherung senkrecht zur Schmalseitenfläche an der Vorderseite von der die Rastnasenausnehmung hintergreifenden Rastnase bewirkt wird. Eine weitere Ausgestaltung dieser Variante gemäß Anspruch 6 gibt der Spannfeder zusätzlich die Funktion einer Lagesicherung des Gehäuses im rückwärtigen Bereich quer zur Einsteckrichtung in der Schmalseitenebene. Zudem erleichtet dies das Ansetzen der Spannfeder am zugehörigen Anschlag.

Bei einer Weiterbildung der Erfindung nach Anspruch 7 ergibt sich eine beidseitige rückwärtige Gehäuselagesicherung in der Richtung senkrecht zu der die Rastaufnahme beinhaltenden Trägerwand durch die an den Spannfederanordnung vorgesehenen Einbuchtungen, gegen die die zugehörigen Anschläge zur Anlage kommen.

Eine Weiterbildung der Erfindung nach Anspruch 8 erlaubt eine kompakte Anordung mehrerer Gehäuse an einem mit geringem Fertigungsaufwand realisierbaren Träger.

Bevorzugte Ausführungsformen der Erfindung sind in den Zeichnungen dargestellt und werden nachfolgend beschrieben. Hierbei zeigen:
- Fig. 1: eine seitliche Schnittansicht einer Gehäuseträgeranordnung, bei der ein Gehäuse mit einer Breitseite gegen eine Trägerplatte anliegend an letzterer verrastet gehalten ist,
- Fig. 2: eine Schnittansicht längs der Linie II-II in Fig. 1,
- Fig. 3: eine vergrößerte Detailansicht des in Fig. 1 umrahmten Bereichs III,
- Fig. 4: eine Schnittansicht längs der Linie IV-IV in Fig. 3,
- Fig. 5: eine seitliche Schnittansicht einer Gehäuseträgeranordnung, bei der ein Gehäuse mit einer Schmalseite gegen eine Trägerplatte anliegend an einem Träger verrastet gehalten ist,
- Fig. 6: eine Schnittansicht längs der Linie VI-VI in Fig. 5,
- Fig. 7: eine Schnittansicht längs der Linie VII-VII in Fig. 5,
- Fig. 8: eine Perspektivansicht eines Trägers für eine Gehäuseträgeranordnung, der zur Aufnahme mehrerer Gehäuse unterschiedlicher Größe eingerichtet ist, und
- Fig. 9: die Ansicht von Fig. 8 bei teilweise von verrastet aufgesteckten Gehäusen belegtem Träger.

Die nachfolgend beschriebenen Ausführungsbeispiele der Erfindung beinhalten verschiedene Gehäuseträgeranordnungen zur rastenden Befestigung von Elektronikgehäusen elektronischer Nutzfahrzeug-Steuergeräte an einem Träger.

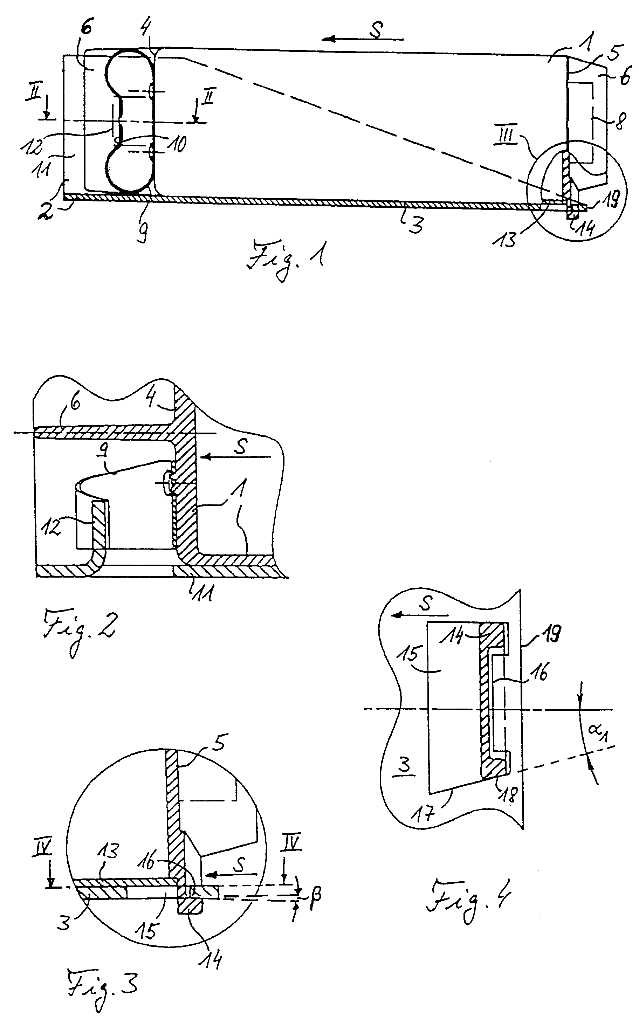

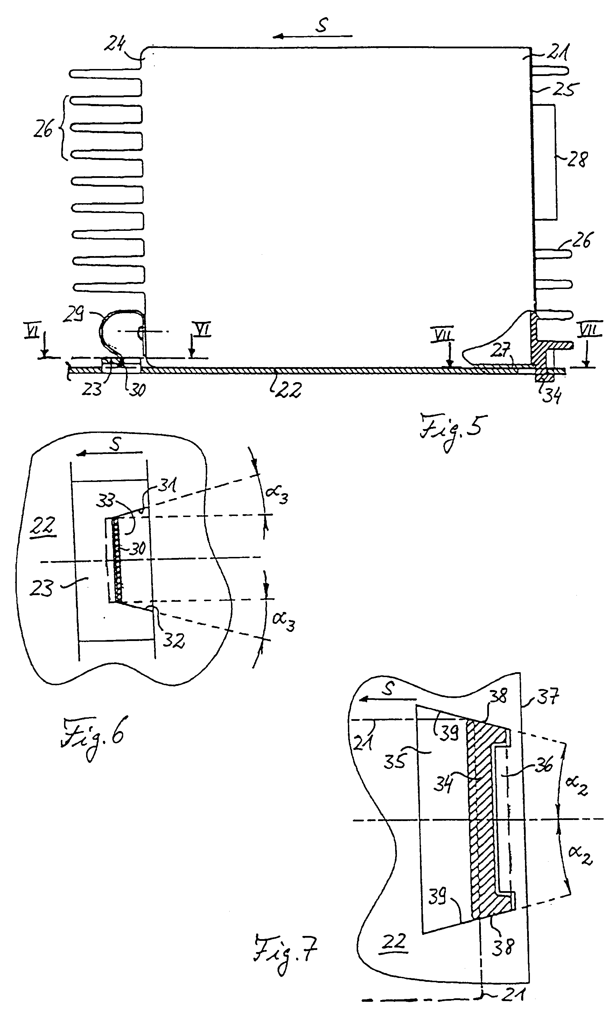

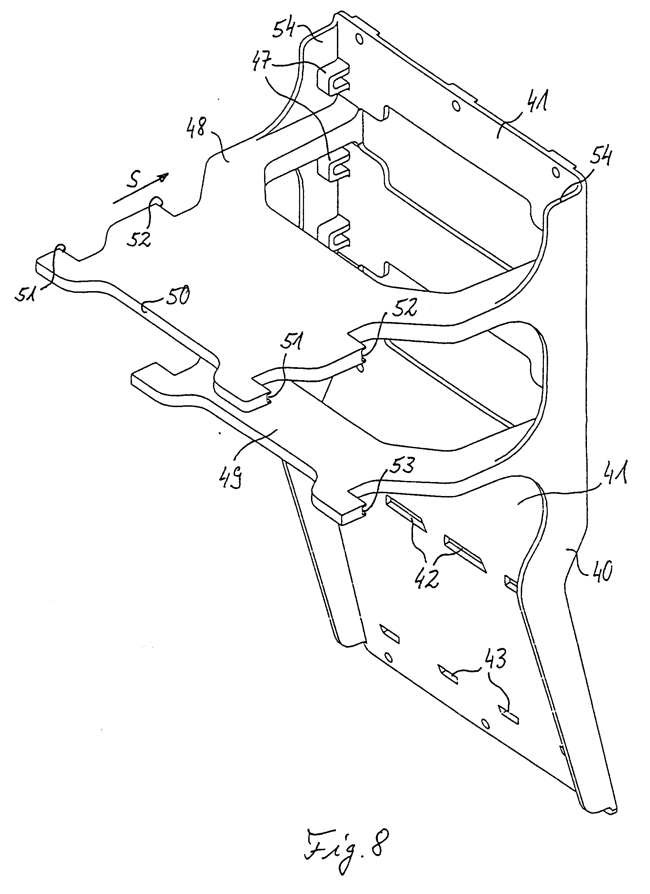

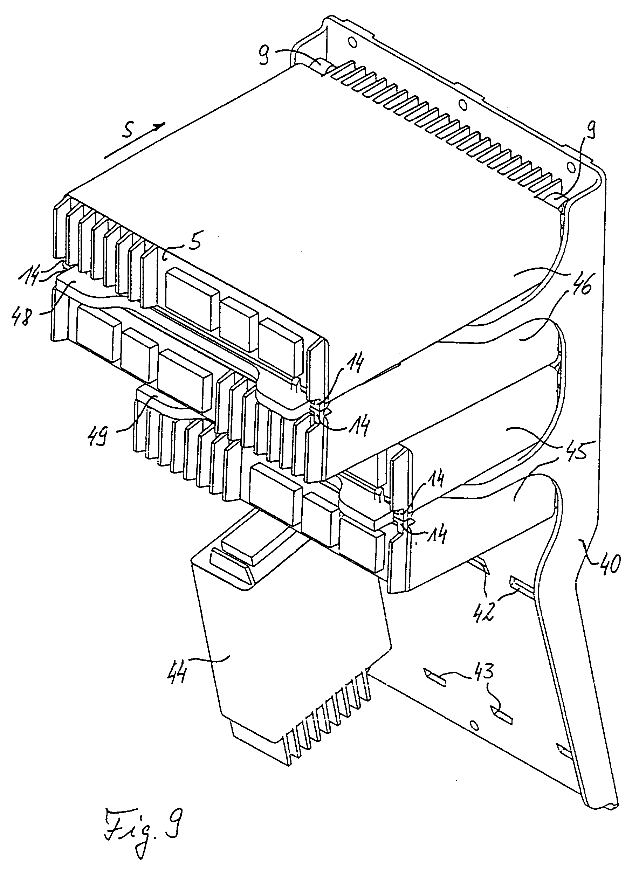

Ein erstes Beispiel, bei dem ein Gehäuse (1) mit einer untenliegenden Breitseite (13) gegen eine Tragplatte (3) eines Trägers (2) anliegt, ist in den Fig. 1 bis 4 veranschaulicht. Das Elektronikgehäuse (1) weist an seiner Rückfläche (4) und seiner Frontfläche (5) Kühlrippen (6) auf. Zusätzlich bildet die Vorderfläche (5) die Steckerseite des Gehäuses (1), an der elektrische Anschlüsse (8) vorgesehen sind. Symmetrisch zur Längsmitelebene des Gehäuses (1) ist an der Gehäuserückfläche (4) in deren Seitenbereichen jeweils eine Spannfedereinheit (9) angeordnet. Jede Spannfedereinheit (9) besteht aus zwei bandförmigen, etwa zu einem Dreiviertel-Kreisbogen gekrümmten Spannfedern, die an einem Ende an die Gehäuserückfläche (4) angenietet sind, während das andere, freie Spannfederende jeweils geradlinig abgewinkelt ist. Die beiden Spannfedern jeder Einheit (9) sind, wie sich aus Fig. 1 ergibt, symmetrisch zur Ebene der halben Gehäusehöhe so angebracht, daß sich ihre geradlinig abgewinkelten, freien Enden in einer zur Gehäuserückfläche (4) parallelen Ebene gegenüberliegen, wodurch in diesem Bereich eine Einbuchtung (10) der Spannfedereinheit (9) entgegen einer Steckrichtung (S), in der das Gehäuse (1) am Träger (2) montiert wird, entsteht. Auf Höhe dieser Einbuchtung (10) sind aus Seitenwänden (11) des Trägers (2) rechteckförmige Bereiche ausgeschnitten und zur Bildung von Spannfederanschlägen (12) rechtwinklig nach innen gebogen, wie besonders aus Fig. 2 zu erkennen. Bei montiertem Gehäuse (1) stützen sich die beiden seitlichen Spannfedereinheiten (9) an der Gehäuserückseite (4) gegen diese Spannfederanschläge (12) ab und erzeugen auf das Gehäuse (1) eine entgegen der mit dem Richtungspfeil (S) markierten Gehäusesteckrichtung wirkende Spannfederkraft. Indem die Spannfederanschläge (12) in den Einbuchtungen (10) der Spannfedereinheiten (9) liegen, wird ein Verrutschen des Gehäuses (1) in diesem rückwärtigen Bereich von der Tragplatte (3) weg verhindert. Seitlich ist das Gehäuse (1) durch die Trägerseitenflächen (11) gesichert, die sich im rückwärtigen Gehäuseeinschubbereich etwa bis zur Gehäusehöhe erstrecken und nach vorne zu, d.h. entgegen der Steckrichtung (S), linear bis zur Höhe der Tragplatte (3) abnehmen, wie durch die gestrichelte Linie in Fig. 1 angedeutet ist.
Im vorderen, unteren Bereich des Gehäuses (1) ist dieses in die Tragplatte (3) des Trägers (2) eingerastet. Die Gestaltung der Rastverbindung ist genauer aus den Fig. 3 und 4 zu erkennen. Das Gehäuse (1) weist hierzu zwei jeweils seitlich an der Gehäusevorderwand (5) in Verlängerung nach unten über die Gehäuseunterseite (13) hinaus angeformte Rastnasen (14) auf, die einen entgegen der Steckrichtung (S) über die sonstige Gehäusekontur vorspringenden Endabsatz beinhalten. Dazu korrespondierend sind in die Tragplatte (3) zwei Rastnasenöffnungen (15) kurz hinter der Vorderkante (19) der Tragplatte (3) eingebracht, so daß zwischen Öffnung (15) und Vorderkante (19) ein Stegbereich (16) verbleibt. Dieser Stegbereich (16) wird bei eingerastet gehaltenem Gehäuse (1) von der zugeordneten Rastnase (14) unterseitig hintergriffen, wobei die gegen die Steckrichtung (S) wirkende Spannfederkraft die Rastnase (14) mit ihrem vornliegenden Absatz gegen den Stegbereich (16), d.h. gegen die entgegen der Steckrichtung (S) liegende Randseite der Rastnasenöffnung (15), drückt. Durch dieses Zusammenwirken von Rastnase (14) und Stegbereich (16) ist das Gehäuse (1) sowohl entgegen der Steckrichtung (S) als auch senkrecht zur Tragplatte (3) gesichert an letzterer verrastet gehalten. Zur erhöhten Stabilisierung der Gehäuselage im Frontbereich sind die absatzbildende Oberseite der Rastnase (14) und die mit dieser in Kontakt tretende Unterseite des Stegbereichs (16) mit der in Fig. 3 gezeigten, geringfügigen vertikalen Schrägung (β) gegenüber der Ebene der Gehäuseunterseite (13) bzw. der Tragplatte (3) versehen. Diese geringfügige Schrägung gewährleistet eine spielfreie Rasthalterung auch noch bei geringfügigen fertigungsbedingten Maßabweichungen, z.B. in der Dicke der Tragplatte (3) oder des Abstands der absatzbildenden Rastnasenoberseite von der sonstigen Gehäuseunterseite. Zudem erleichtert das Vorsehen dieses geringfügigen Schrägwinkels (β) die Einrastbewegung.

Durch geeignete Gestaltung der in Gehäusequerrichtung äußeren Seitenränder der Rastnasenöffnungen (15) und der Rastnasen (14) wird außerdem eine Stabilisierung des Gehäuses (1) im Frontbereich parallel zur Tragplattenebene und quer zur Steckrichtung (S) erzielt. Speziell verlaufen die der Längsmitte der Anordnung zugewandten Seitenränder exakt parallel zur Steckrichtung (S), während die den Trägerseitenwänden (11) zugewandten Seitenränder (17, 18) schräg in einem spitzen Winkel (α₁) von vorliegend 15° zu dieser Richtung, d.h. zur Gehäuselängsrichtung, verlaufen. Aufgrund dieser einseitigen Schrägung von Öffnungsrändern (17) und Rastnasenseitenflächen (18) wird zusammen mit der die Rastnasen (14) in Richtung Tragplattenvorderkante (19) drückenden Spannfederwirkung erreicht, daß selbst bei fertigungsbedingten Maßabweichungen in der Weite der Öffnungen (15) oder der Breite der Rastnasen (14) letztere in Querrichtung jeweils gegen die zugehörige Öffnungsrandseite anliegen, wie dies aus Fig. 4 für die eine der beiden Gehäuserastnasen (14) zu ersehen ist. Somit ist das Gehäuse (1) frontseitig auch in dieser Querrichtung spielfrei an der Tragplatte (3) gehalten.

Aus den Fig. 1 bis 4 und der obigen Beschreibung ist bereits ersichtlich, daß das Gehäuse (1) nicht nur sehr sicher am Träger (2) verrastet gehalten wird, sondern daß dies auch mit einer besonders einfachen Montage und Demontage einhergeht. Um das Gehäuse in die in Fig. 1 gezeigte, montierte Lage zu verbringen, wird es in der Steckrichtung (S) entlang der Tragplatte (3) in den Träger (2) eingeschoben, bis sich die Spannfedereinheiten (9) gegen die zugeordneten Anschläge (12) anlegen. Das Gehäuse (1) wird daraufhin gegen die Spannfederkraft weiter in Steckrichtung (S) gedrückt, wobei es frontseitig geringfügig von der Tragplatte (3) abgehoben wird, damit die Rastnase (14) über den Stegbereich (16) hinweggeführt werden kann. Sobald sich die jeweilige Rastnase (14) vollständig über der zugehörigen Rastnasenöffnung (15) befindet, wird das Gehäuse (1) frontseitig wieder gegen die Tragplatte (3) angelegt, wodurch die Rastnasen (14) durch die zugehörigen Rastnasenöffnungen (15) hindurchgeführt werden. Anschließend wird dem Druck der Spannfedereinheiten (9) entgegen der Steckrichtung (S) nachgegeben, wonach die Rastnasen (14) die Tragplatte (3) hintergreifen, indem sie unter deren Stegbereich (16) geschoben werden. Sobald die Schmalseiten der Rastnasen (14) gegen die zugehörigen Öffnungsrandseiten anliegen, insbesondere die Rastnasenschrägfläche (18) gegen die Öffnungsrandschrägseite (17), ist die endgültige Gehäuselage erreicht. In dieser Lage ist das Gehäuse (1) parallel zur Steckrichtung (S) durch die gegen die Anschläge (12) abgestützten Spannfedereinheiten (9) und die Rastverbindungen (14 bis 19), senkrecht zur Tragplatte (3) durch das Anliegen der Gehäuseunterseite (13) gegen die Tragplatte (3), die in den Spannfedereinbuchtungen (10) liegenden Anschläge (12) und die die Tragplattenstegbereiche (16) hintergreifenden Rastnasen (14) sowie quer zur Steckrichtung (S) in der Tragplattenebene durch die Trägerseitenwände (11) und die zusammenwirkenden Schmalseiten der Rastnasen (14) und Rastnasenöffnungen (15) jeweils sowohl im rückwärtigen wie auch im frontseitigen Bereich sicher am Träger (2) gehalten.

Ebenso einfach wie die Montage erfolgt auch die Demontage des Gehäuses (1) vom Träger (2) durch Wiederholen der Montagebewegungen in umgekehrter Richtung. Das Gehäuse (1) wird also zu diesem Zweck zuerst in Steckrichtung (S) gegen die Spannfederkraft gedrückt, bis die Rastnasen (14) aus den Rastnasenöffnungen (15) herausgeführt werden können, wonach dem Spannfederdruck nachgegeben wird und das Gehäuse entgegen der Steckrichtung (S) vom Träger (2) weggenommen werden kann. Daraus folgt, daß weder zur Montage, noch zur Demontage des Gehäuses (1) irgendein Werkzeug erforderlich oder außer dem Gehäuse (1) selbst irgendein Gegenstand ergriffen oder betätigt werden muß.

Neben diesem Handhabungsvorteil ist diese Gehäuseträgeranordnung auch konstruktiv und fertigungstechnisch von Vorteil. So ist der Träger (2) als einstückiges Formteil herstellbar, ohne daß zusätzliche Elemente an ihm angebracht werden müssen. Auch am Gehäuse (1) ist lediglich die Anbringung der Spannfedereinheiten (9) notwendig, hingegen entfallen jegliche weiteren Befestigungselemente, wie Schrauben oder bewegliche Rastverbindungsteile. Gleichwohl ist durch die gezeigte Gestaltung der Gehäuserastbefestigung gewährleistet, daß sie selbst ruckartigen Stoßeffekten bis zum Vierfachen der Erdbeschleunigung standhält, wie sie beim Betrieb des Fahrzeuges auftreten können.

Während alternativ die Spannfedereinheiten und die Rastverbindungen auch seitlich am Gehäuse in einem Bereich zwischen Gehäusevorderseite und -rückseite vorgesehen sein können, hat die gezeigte Anordnung den Vorteil, daß die zugehörigen Befestigungspunkte in Steckrichtung maximal beabstandet sind, wodurch sich eine hohe Lagesicherheit ergibt.

In den Fig. 5 bis 7 ist eine Variante der obigen Gehäuseträgeranordnung dargestellt. Bei dieser Anordnung ist ein Gehäuse (21) mit einer Schmalseite (27) gegen einen von einer Halteplatte (22) gebildeten Träger anliegend an letzterem verrastet gehalten. Das Gehäuse (21) ist wiederum an seiner Rückfläche (24) mit Kühlrippen (26) sowie an seiner Frontseite (25) ebenfalls mit Kühlrippen (26) sowie mit elektrischen Steckanschlüssen (28) versehen. An der Gehäuserückseite (24) ist in dem Bereich, der an die gegen den Träger (22) anzulegende Schmalseite (27) angrenzt, eine bandförmige Spannfeder (29) mit einem Ende angenietet, die wiederum etwa in einem Dreiviertelkreis gebogen ausgeführt ist. Das freie Spannfederende (30) ist bei dieser Spannfeder (29) entgegen der sonstigen Spannfederkrümmung umgebogen und endet in etwa in der Ebene der zugehörigen Schmalseite (27). Dazu korrespondierend weist der plattenförmige Träger (22) einen sich bügelförmig erhebenden Spannfederanschlag (23) auf, dessen Kontur aus den Fig. 5 und 6 hervorgeht. Insbesondere ist durch den Bügel (23) eine U-förmige, entgegen der Steckrichtung (S) offene Aufnahme (33) gebildet, wobei deren begrenzende Innenseiten (31, 32) in einem spitzen Winkel (α₃) von vorliegend 15° parallel zur Steckrichtung (S) und damit zur Gehäuselängsrichtung derart verlaufen, daß sich die Aufnahme (33) entgegen der Steckrichtung (S) erweitert. Auf diese Weise läßt sich das Spannfederband (29) mit seinem freien, abgewinkelten Ende (30) zentrierend in die Bügelaufnahme (33) einführen, bis dessen Breite der Weite der Aufnahme (33) entspricht. Durch die insbesondere aus Fig. 5 ersichtliche Abwinklung des freien Spannfederendes (30) bildet die Spannfeder (29) ihrerseits eine Einbuchtung, gegen welche der als Spannfederanschlag dienende Bügel (23) so zur Anlage kommt, daß damit das Gehäuse (21) an seiner Rückseite (24) gegen ein Lösen senkrecht von der Trägerplatte (22) weg gesichert ist. Die gleichzeitig zentrierende und klemmende Einfügung der Spannfeder (29) in die U-förmige Aufnahme (33) sichert das Gehäuse (21) in seinem rückwärtigen Bereich zudem gegen Bewegungen in der Trägerebene quer zur Steckrichtung (S). Parallel zur Steckrichtung (S) ist das Gehäuse (21) durch das Andrücken der Spannfeder (29) gegen den trägerseitigen Bügel (23) federelastisch gehalten.

An der Frontseite (25) ist das Gehäuse (21) durch eine Rastverbindung festgelegt, die weitgehend derjenigen des voranstehenden Beispiels gleich ist, wobei hier nur eine einzige Rastnase (34) vorgesehen ist. Die Rastnase (34) ist durch eine Rastnasenöffnung (35) hindurchführbar und hintergreift dann unterseitig einen frontseitigen Stegbereich (36) der Trägerplatte (22) hinter deren Vorderkante (37) entsprechend dem obigen Beispiel. Dies ist in Fig. 7 genauer zu erkennen, wobei zur Orientierung die Kontur des Gehäuses (21) zusätzlich gestrichelt angedeutet ist. Die Oberseite des Absatzes der Rastnase (34) sowie die Unterseite des Stegbereichs (36) sind mit derselben, geringfügigen Schrägung (β) gegenüber der Trägerplattenebene versehen wie zum obigen Beispiel beschrieben, wobei sich dieselben Vorteile wie oben erläutert ergeben. Da an dem Gehäuse (21) nur eine einzige Rastnase (34) an der Vorderseite (25) angeformt ist, sind deren gehäusequerseitigen Schmalseiten (38) im Gegensatz zu den Rastnasen des obigen Beispiels beide schräg verlaufend ausgebildet, indem sie jeweils einen spitzen Winkel (α₂) von vorliegend 15° zur Gehäuselängsrichtung bilden. Dazu passend sind die zugehörigen Seitenränder (39) der Rastnasenöffnung (35) ebenfalls beide um denselben Winkel (α₂) zur Steckrichtung (S) geschrägt, wobei sich die Öffnungsweite entgegen der Steckrichtung (S) verringert.

Im Zusammenwirken mit der entgegen der Steckrichtung (S) auf das Gehäuse (21) und damit die Rastnase (34) wirkenden Spannfederkraft resultiert diese Gestaltung wiederum in einer in Querrichtung klemmenden Positionierung der Rastnase (34) in der Öffnung (35) zwecks spielfreier frontseitiger Sicherung der Gehäuselage gegen Bewegungen in der Trägerebene quer zur Steckrichtung (S). Gleichzeitig lassen sich damit Fertigungstoleranzen ausgleichen.

Auch im übrigen sind die bereits zum obigen Beispiel genannten Vorteile einer solchen Gehäuseträgeranordnung mit spannfederelastisch an einem Träger verrasteten Gehäuse auf dieses Beispiel übertragbar. So ist auch hier der Träger (22) als einteiliges Formteil realisierbar, ohne daß zusätzliche Elemente an ihm anzubringen sind. Am Gehäuse (21) ist wiederum die Rastnase (34) angeformt, und nur die Spannfeder (29) ist anzunieten. Montage und Demontage erfolgen auch hier lediglich durch Handhaben des Gehäuses (21) selbst. Zur Montage wird die Spannfeder (29) gegen den Bügelanschlag (23) angesetzt und das Gehäuse (21) in Steckrichtung (S) gegen die Spannfederkraft weitergedrückt, bis die Rastnase (34) über der Öffnung (35) liegt und beim anschließenden Anlegen der zugehörigen Gehäuseschmalseite (27) gegen die Trägerplatte (22) durch die Öffnung (35) hindurchgeführt wird. Danach wird dem Spannfederdruck entgegen der Steckrichtung (S) nachgegeben, wodurch die Rastnase (34) mit dem Trägerstegbereich (36) wie gezeigt verrastet. Das Gehäuse (21) ist dann rückseitig und frontseitig nach allen Richtungen lagegesichert gehalten, wobei die Befestigung lediglich in der Steckrichtung (S) gegen die Spannfederkraft nachgiebig ist, wie dies ebenso bei dem obigen Beispiel der Fall ist. Ersichtlich erfolgt auch die Demontage wiederum allein durch Handhaben des Gehäuses in einem zur Montage gegenläufigen Bewegungsablauf.

In den Fig. 8 und 9 ist ein Ausführungsbeispiel gezeigt, bei dem an einem einzigen, einteiligen Träger (40) eine Vielzahl von in drei verschiedenen Größen standardisiert gefertigten Gehäusen (44, 45, 46) variabel und raumsparend angebracht werden kann. Der Träger ist wiederum mit geringem Herstellungsaufwand als einstückiges Gußteil gefertigt, ohne daß zusätzliche Elemente anzubringen sind. Er weist eine Rückwand (41) auf, die so strukturiert ist, daß der Träger (40) beispielsweise vor dem Fußraum in einem Nutzfahrzeug-Führerhaus angebracht werden kann. In der unteren Hälfte der Rückseite (41) sind mehrere Rastnasenöffnungen (42) und nach unten im Abstand von diesen jeweils ein zugehöriger Spannfederanschlag (43) vorgesehen, wobei letzere ebenfalls aus jeweils einer Öffnung in der Trägerrückfläche (41) bestehen. An jeweils einer Spannfederanschlagöffnung (43) und der gegenüberliegenden Rastnasenöffnung (42) ist ein Gehäuse (44) in der zu den Fig. 5 bis 7 beschriebenen Art mit einer Schmalseite gegen die Trägerrückwand (41) anliegend verrastend befestigbar. In Fig. 9 ist der Träger (40) mit einem solchen Gehäuse (44) bestückt dargestellt. Dabei wird die an der Gehäuserückseite seitlich benachbart zu einer Gehäuseschmalseite angebrachte Spannfeder mit ihrem freien Ende in die Spannfederanschlagöffnung (43) eingesetzt, das Gehäuse (44) anschließend nach unten gedrückt und mit der vorderseitig angeformten Rastnase in die zugehörige Rastnasenöffnung (42) eingeführt. Diese Befestigungsart ist für das Gehäuse mit dem geringsten Volumen aus dem Satz von drei verschieden großen Gehäusemodulen (44, 45, 46) vorgesehen.

Alle drei Gehäusemodulgrößen (44, 45, 46) besitzen dieselbe Höhe. Das Gehäuse (45) mit der mittleren Größe besitzt dieselbe Länge wie das kleinste Gehäuse (44), jedoch eine größere Breite. Das Gehäuse (46) mit dem größten Volumen besitzt dieselbe Breite wie das mittelgroße Gehäuse (45), jedoch eine größere Länge. Im Unterschied zu dem kleinsten Gehäuse (44) sind die beiden größeren Gehäuse (45, 46) an dem Träger (40) nach Art des zu den Fig. 1 bis 4 beschriebenen Beispiels festlegbar. Dazu besitzen diese Gehäuseformen (45, 46) den zu diesem obigen Beispiel beschriebenen Aufbau mit den beiden seitlich an der Gehäuserückwand angeordneten Spannfedereinheiten (9) und den frontseitig an der Vorderwand (5) angeformten Rastnasen (14). Zur Halterung dieser beiden größeren Gehäuse (45, 46) erstrecken sich senkrecht von der Rückwand (41) im Abstand parallel zueinander verlaufend zwei Halteplatten (48, 49). Dabei besitzt die eine Halteplatte (48) eine größere Länge parallel zur Gehäusesteckrichtung (S) und ist nahe ihrer Vorderkante (50) mit einem ersten Paar seitlicher Rastnasenaufnahmeschlitze (51) sowie zur Rückwand (41) hin versetzt mit einem zweiten Paar derartiger Rastnasenaufnahmeschlitze (52) versehen. Die andere Halteplatte (53) ist demgegenüber verkürzt und besitzt lediglich ein Paar solcher seitlicher Rastnasenaufnahmeschlitze (53), deren Abstand zur Rückwand (41) demjenigen der näher zur Rückwand (41) gelegenen Rastnasenaufnahmeschlitze (52) an der längeren Halteplatte (48) entspricht.

An der Rückwand (41) sind jeweils im Seitenbereich oberhalb und unterhalb einer jeden Halteplatte (48, 49) Spannfederanschlagnocken (47) angeformt, deren Gestalt sich aus Fig. 8 ergibt. Die Spannfederanschläge (47) grenzen dabei zusätzlich an versteifende Trägerseitenflächen (54) an und dienen jeweils zur Abstützung einer gehäuseseitigen Spannfedereinheit (9), wobei sie in ihrer Funktion dem abgewinkelten Anschlag (12) des Beispiels der Fig. 1 bis 4 entsprechen. Die Trägerseitenbereiche (54) sichern die Gehäuselage in der Ebene der Halteplatten (48, 49) quer zur Steckrichtung (S) im rückwärtigen Bereich. Die Rastnasenaufnahmeschlitze (51 bis 53) übernehmen die Funktion der Rastöffnungen (15) des Beispiels der Fig. 1 bis 4, wobei sie jedoch mit einer Schlitzweite ausgebildet sind, welche die Einfügung zweier Rastnasen (14) in einen Aufnahmeschlitz (51 bis 53) erlauben. Auf diese Weise ist es möglich, in der in Fig. 9 dargestellten Art an jeder Halteplatte (48, 49) zwei Gehäuse (45, 46) an den gegenüberliegenden Seiten der Halteplatte (48, 49) zu halten.

Dies realisiert eine besonders raumsparende, verrastet steckbare Gehäuseanbringung an dem Träger (40). Dabei ist das unter einer Halteplatte (48, 49) gehaltene Gehäuse lediglich um 180° um seine Längsachse gedreht gegenüber dem Gehäuse oberhalb derselben Halteplatte (48, 49) angebracht, wobei sich bei gleich großen Gehäusen deren Rastnasen (14) benachbart im selben Aufnahmeschlitzpaar aufgenommen gegenüberliegen. Auf diese Weise kann jedes Gehäuse wahlweise an der Ober- oder der Unterseite einer Halteplatte angeordnet werden. Während an der verkürzten Halteplatte (49) spezifisch die Gehäuse (45) mittlerer Größe montierbar sind, ist es neben der in Fig. 9 gezeigten Montage der größten Gehäuse (46) an der längeren Halteplatte (48) alternativ möglich, ein oder zwei Gehäuse (45) der mittleren Größe an selbiger festzulegen.

An dem Träger (40) lassen sich somit bis zu vier Gehäuse (44) der kleinsten Größe sowie vier Gehäuse (45, 46) mit dem mittleren und dem größten Volumen, davon wenigstens zwei von der mittleren Größe (45) äußerst platzsparend und mit extrem geringem Montage- und Demontageaufwand sowie sehr geringem konstruktivem Aufwand verrastet festlegen. Dabei können je nach Bedarf einzelne Gehäusesteckplätze am Träger (40) unbelegt bleiben oder an der langen Trägerplatte (48) ein längeres Gehäuse (46) und ein kürzeres Gehäuse (45) angeordnet sein, ohne daß jeweils die Haltefähigkeit der spannfedergesicherten Rastverbindungen aller am Träger (40) befestigter Gehäuse beeinträchtigt wird. Folglich kann der Träger (40) einheitlich für verschiedene Nutzfahrzeugtypen Verwendung finden, wobei die Elektronikgehäuse der für das jeweilige Nutzfahrzeug vorgesehenen Steuergeräte an diesem Träger (40) festgelegt werden können.

Es versteht sich, daß sich für den Fachmann weitere Varianten der oben beschriebenen erfindungsgemäßen Ausführungsbeispiele je nach Bedarf anbieten, wobei der Anwendungsbereich sich selbstverständlich nicht auf Nutzfahrzeuge beschränkt ist. Vielmehr ist die Erfindung überall dort von Nutzen, wo Gehäuse an einem anderen Bauteil lösbar verrastet werden sollen. Charakteristisch ist jeweils das Fehlen jeglicher am Träger zusätzlich anzubringender Befestigungselemente sowie die Möglichkeit, die Gehäuse allein durch Handhabung derselben ohne Werkzeug und Bedienung beweglicher Befestigungselemente durch eine einfache Steckbewegung montieren und demontieren zu können.

## Patentansprüche

1. Gehäuseträgeranordnung, insbesondere von Nutzfahrzeug-Elektronikgehäusen, mit
- einem Träger (2),
- wenigstens einem Gehäuse (1), das durch Zusammenwirken eines oder mehrerer Rastelementpaare in Form jeweils einer Rastnase (14) und einer Rastnasenaufnahme (15), von denen sich jeweils das eine Element am Träger und das andere Element am Gehäuse befindet, am Träger rastend befestigbar ist, und
- wenigstens einer Spannfedereinheit (9) am Gehäuse (1) und einem der Spannfedereinheit zugeordneten Spannfederanschlag (12) am Träger (2), wobei
- das Gehäuse in einer Steckrichtung (S) und entgegen der Steckrichtung gesichert am Träger festlegbar ist, wobei die gegen die Steckrichtung wirkende Sicherung durch die von der Spannfederkraft bewirkte Anlage der Rastnase (14) an einem von ihr hintergriffenen Rastaufnahmerand (16) bewirkt wird,
**dadurch gekennzeichnet, daß**
- die in Steckrichtung (S) wirkende Sicherung der Gehäusefestlegung am Träger (2) durch Abstützung der Spannfedereinheit am Spannfederanschlag bewirkt wird,
- zum Lösen des Gehäuses (1) vom Träger (2) die Rastnase von der den Aufnahmerand hintergreifenden Position durch Verschieben des Gehäuses in Steckrichtung entgegen der Spannfederkraft in eine von der Rastnasenaufnahme freigegebene Position bewegbar und anschließend durch eine Gehäusebewegung senkrecht zur Steckrichtung aus der Aufnahme herausführbar ist, und
- wenigstens eine (18) der sich quer zur Steckrichtung (S) gegenüberliegenden Rastnasenseitenflächen und die gegen diese zur Anlage kommende Randseite (17) der Rastnasenaufnahme (15) in spitzem Winkel (α₁) zur Steckrichtung verlaufend ausgebildet sind, wobei sich die Breite der Rastnase und die Weite der Rastnasenaufnahme entgegen der Steckrichtung verringern.

2. Gehäuseträgeranordnung, insbesondere von Nutzfahrzeug-Elektronikgehäusen, mit
- einem Träger (2),
- wenigstens einem Gehäuse (1), das durch Zusammenwirken eines oder mehrerer Rastelementpaare in Form jeweils einer Rastnase (14) und einer Rastnasenaufnahme (15), von denen sich jeweils das eine Element am Träger und das andere Element am Gehäuse befindet, am Träger rastend befestigbar ist, und
- wenigstens einer Spannfedereinheit (9) am Gehäuse (1) und einem der Spannfedereinheit zugeordneten Spannfederanschlag (12) am Träger (2), wobei
- das Gehäuse in einer Steckrichtung (S) und entgegen der Steckrichtung gesichert am Träger festlegbar ist, wobei die gegen die Steckrichtung wirkende Sicherung durch die von der Spannfederkraft bewirkte Anlage der Rastnase (14) an einem von ihr hintergriffenen Rastaufnahmerand (16) bewirkt wird,
**dadurch gekennzeichnet, daß**
- die in Steckrichtung (S) wirkende Sicherung der Gehäusefestlegung am Träger (2) durch Abstützung der Spannfedereinheit am Spannfederanschlag bewirkt wird,
- zum Lösen des Gehäuses (1) vom Träger (2) die Rastnase von der den Aufnahmerand hintergreifenden Position durch Verschieben des Gehäuses in Steckrichtung entgegen der Spannfederkraft in eine von der Rastnasenaufnahme freigegebene Position bewegbar und anschließend durch eine Gehäusebewegung senkrecht zur Steckrichtung aus der Aufnahme herausführbar ist, und
- der Träger (40) wenigstens eine Halteplatte (48) beinhaltet, welche zwei in Steckrichtung (S) beabstandete Paare von Rastnasenaufnahmen (51, 52) zur wahlweisen Aufnahme eines von zwei unterschiedlichen Gehäusen (45, 46) mit verschiedenem Abstand der Rastnasen (14) von der Gehäuserückfläche aufweist und/oder welche Rastnasenaufnahmen (51, 52) aufweist, die zur Aufnahme zweier Rastnasen (14) von auf gegenüberliegenden Seiten der Halteplatte aufsteckbaren Gehäusen (46) eingerichtet sind, wobei Spannfederanschlagnocken (47) oberhalb und unterhalb der Halteplatte am Träger angeformt sind.

3. Gehäuseträgeranordnung nach Anspruch 2, weiter
**dadurch gekennzeichnet, daß**
wenigstens eine der sich quer zur Steckrichtung (S) gegenüberliegenden Rastnasenseitenflächen und die gegen diese zur Anlage kommende Randseite der Rastnasenaufnahme in spitzem Winkel (α₁) zur Steckrichtung verlaufend ausgebildet sind, wobei sich die Breite der Rastnase und die Weite der Rastnasenaufnahme entgegen der Steckrichtung verringern.

4. Gehäuseträgeranordnung nach einem der Ansprüche 1 bis 3, weiter
**dadurch gekennzeichnet, daß**
die Spannfedereinheit (9) an einer Gehäuserückwand (4) befestigt und die Rastnase (14) an einer Gehäusevorderwand (5) angeformt ist.

5. Gehäuseträgeranordnung nach einem der Ansprüche 1 bis 4, weiter
**dadurch gekennzeichnet, daß**
- Rastnase (34) und Spannfedereinheit (29) im Bereich einer Gehäuseschmalseite (27), die gegen eine die Rastnasenaufnahme (35) aufweisende Trägerwand (22) anlegbar ist, angeordnet sind und
- die Spannfedereinheit als gebogenes Federband ausgebildet ist, das am einen Ende am Gehäuse (21) festgelegt und an seinem anderen, freien Ende (30) eine Einbuchtung entgegen der Steckrichtung (S) bildend abgebogen ist, in welcher der Spannfederanschlag (23) das Gehäuse senkrecht zur Schmalseite (27) sichernd aufnehmbar ist.

6. Gehäuseträgeranordnung nach Anspruch 5, weiter
**dadurch gekennzeichnet, daß**
der Spannfederanschlag (23) als U-förmige, in Steckrichtung (S) offene Begrenzung gestaltet ist, in deren Ausnehmung (33) die Spannfeder (29) einführbar ist, wobei sich die Weite der Ausnehmung entgegen der Steckrichtung (S) vergrößert, indem wenigstens eine zugehörige Begrenzungsseite (31, 32) in spitzem Winkel (α₃) zur Steckrichtung (S) verläuft.

7. Gehäuseträgeranordnung nach einem der Ansprüche 1 bis 4, weiter
**gekennzeichnet durch**
- Spannfedereinheiten (9) in Form von jeweils zwei einseitig an den Seitenbereichen der Gehäuserückfläche (4) befestigten Federbändern, deren freie Enden gegeneinanderliegend eine Spannfedereinbuchtung (10) entgegen der Steckrichtung (S) bilden, gegen die der Spannfederanschlag (12) das Gehäuse (1) senkrecht zu einer Trägerwand (3) sichernd zur Anlage kommt, wobei
- das Gehäuse mit einer Breitseite (13) gegen die Trägerwand (3), welche die Rastnasenaufnahme (15) aufweist, anliegend festlegbar ist.

8. Gehäuseträgeranordnung nach einem der Ansprüche 1 bis 7, weiter
**dadurch gekennzeichnet, daß**
der Träger (40) als einstückiges Formteil zur rastbaren Befestigung mehrerer Gehäuse (44, 45, 46) ausgebildet ist.

## Claims

1. Housing Support arrangement, in particular for housings of electronic systems in commercial vehicles, comprising
- a support (2),
- at least one housing (1) which can be attached by clipping to the support by virtue of the cooperation between one or more pairs of detent elements each in the form of a detent lug (14) and a detent recess (15), of which in each case one element is located on the support and the other element is located on the housing, and
- at least one tensioning spring unit (9) on the housing (1) and a tensioning spring end-stop (12), associated with the tensioning spring unit, on the support (2), such that
- the housing can he fixed on the support by insertion along a direction (S) and is secured against movement in the direction opposite to the insertion direction, in that it is retained in the insertion direction by the action of the tensioning spring force which holds the detent catch (14) against a detent recess rim (16) which the lug engages from behind,
**characterised in that**
- the position of the housing is secured on the support (2) in the insertion direction (S) by the pressure of the tensioning spring unit against the tensioning spring end-stop,
- to release the housing (1) from the support (2), the detent lug can be moved from the position in which it engages with the rim of the detent recess from behind by displacing the housing in the insertion direction against the force of the tensioning spring and into a position where the detent lug can move clear of the detent recess, and the lug is then lifted clear of the recess by moving the housing perpendicularly to the insertion direction, and
- at least one (18) of the detent lug side surfaces opposite one another transversely to the insertion direction (S) and the side (17) of the rim of the detent recess (15) which comes in contact against this are formed so as to extent at an acute angle (α₁) relative to the insertion direction, such that the width of the detent lug and the width of the detent recess decrease in the direction opposite to the insertion direction.

2. Housing support arrangement, in particular for housings of electronic systems in commercial vehicles, comprising
- a support (2),
- at least one housing (1) which can be attached by clipping to the support by virtue of the cooperation between one or more pairs of detent elements each in the form of a detent lug (14) and a detent recess (15), of which in each case one element is located on the support and the other element is located on the housing, and
- at least one tensioning spring unit (9) on the housing (1) and a tensioning spring end-stop (12), associated with the tensioning spring unit, on the support (2), such that
- the housing can be fixed on the support by insertion along a direction (S) and is secured against movement in the direction opposite to the insertion direction, in that it is retained in the insertion direction by the action of the tensioning spring force which holds the detent catch (14) against a detent recess rim (16) which the lug engages from behind,
**characterised in that**
- the position of the housing is secured on the support (2) in the insertion direction (S) by the pressure of the tensioning spring unit against the tensioning spring end-stop,
- to release the housing (1) from the support (2), the detent lug can he moved from the position in which it engages with the rim of the detent recess from behind by displacing the housing in the insertion direction against the force of the tensioning spring and into a position where the detent lug can move clear of the detent recess, and the lug is then lifted clear of the recess by moving the housing perpendicularly to the insertion direction, and
- the support (40) comprises at least one holding plate (44), which comprises two pairs of detent retaining notches (51, 52) some distance apart in the insertion direction (S) for the selective fitting of one of two different housings (45, 46) with their detent lugs (14) located different distances away from the back surface of the housing, and/or which comprises detent notches (51, 52) positioned such that two detent lugs (14) belonging to housings (46) that can be inserted on opposite sides of the holding plate are accommodated, for which purpose tensioning spring end-stop projections (47) are formed on the support both on top of and underneath the holding plate.

3. Housing support arrangement according to Claim 2, further
**characterised in that**
at least one of the detent lug side surfaces opposite one another transversely to the insertion direction (S) and the side of the rim of the detent recess which comes in contact against this are formed so as to extend at an acute angle relative to the insertion direction, such that the width of the detent lug and the width of the detent recess decrease in the direction opposite to the insertion direction.

4. Housing support arrangement according to any of Claims 1 to 3, further
**characterised in that**
the tensioning spring unit (9) is attached to a back wall (4) of the housing and the detent lug (14) is formed on a front wall of the housing.

5. Housing support arrangement according to any of Claims 1 to 4, further
**characterised in that**
- the detent lug (34) and the tensioning spring unit (29) are arranged in the area of a narrow side (27) of the housing, which can be positioned in contact with a support wall (22) which comprises the detent recess (35), and
- the tensioning spring unit is formed as a curved strip spring, which at one end rests against the housing (21) and at its other, free end (30) is bent at an angle to form a salient opposite to the insertion direction (S), in which the tensioning spring end-stop (23) on the housing can be accommodated securely perpendicularly to the said narrow side (27).

6. Housing support arrangement according to Claim 5, further
**characterised in that**
the tensioning spring end-stop (23) is designed as a U-shaped restricting element open in the insertion direction (S), into whose hollow (33) the tensioning spring (29) can be introduced, such that the width of the hollow increases towards the direction opposite to the insertion direction (S), in that at least one of the associated limiting sides (31, 32) extends at an acute angle (α₃) with respect to the insertion direction (S).

7. Housing support arrangement according to any of Claims 1 to 4, further
**characterised in that** it comprises
- tensioning spring units (9) each in the form of two strip springs attached at one end to the sides of the back surface (4) of the housing, whose free ends in contact with one another form a tensioning spring salient (10) towards the direction opposite to the insertion direction (S), against which the tensioning spring end-stop (12) makes secure contact with the housing (1) perpendicularly to a support wall (3), such that
- the housing can be positioned with a long side (13) in contact against the support wall (3) which comprises the detent recess (15).

8. Housing support arrangement according to any of Claims 1 to 7, further
**characterised in that**
the support (40) is formed as a one-piece moulded component for the secured attachment of several housings (44, 45, 46).

## Revendications

1. Dispositif de supports pour boîtiers, en particulier pour boîtiers de dispositifs électroniques dans des véhicules utilitaires, comportant :
◆ un support (2),
◆ au moins un boîtier (1), qui peut être fixé avec encliquetage, sur le support, par une coopération d'une ou plusieurs paires d'éléments d'encliquetage se présentant sous la forme chaque fois d'un ergot d'encliquetage (14) et d'un logement d'ergot d'encliquetage (15), dont chaque fois un élément se trouve sur le support et l'autre élément sur le boîtier, et
◆ au moins une unité de ressort tendeur (9) sur le boîtier (1) et une butée de ressort tendeur (12), associée à l'unité de ressort tendeur, sur le support (2), où
◆ le boîtier peut être fixé sur le support, en étant assuré dans une direction d'enfichage (S) et à l'encontre de la direction d'enfichage, la sécurité agissant à l'encontre de la direction d'enfichage étant provoquée par la mise en appui, provoquée par la force du ressort tendeur, de l'ergot d'encliquetage (14) sur une bordure (16) du logement d'encliquetage, saisie par l'arrière par celui-ci,
**caractérisé en ce que**
◆ la sécurité agissant dans la direction d'enfichage (S) de la fixation de boîtier sur le support (2) étant provoquée par la mise en appui de l'unité à ressort tendeur sur la butée de ressort tendeur,
◆ pour désolidariser le boîtier (1) du support (2), l'ergot d'encliquetage est déplaçable de la position saisissant par l'arrière le bord du logement, par un déplacement du boîtier dans la direction d'enfichage, à l'encontre de la force exercée par le ressort tendeur, en une position libérée du logement de l'ergot d'encliquetage et, ensuite, le boîtier est susceptible d'être extrait du logement perpendiculairement à la direction d'enfichage, par un déplacement du boîtier, et
◆ au moins l'une (18) des faces latérales de l'ergot d'encliquetage, opposée et orientée transversalement par rapport à la direction d'enfichage (S), et la face de bordure (17), venant en appui contre celle-ci, du logement (15) de l'ergot d'encliquetage étant réalisées en s'étendant sous un angle aigu (α₁) par rapport à la direction d'enfichage, la largeur de l'ergot d'encliquetage et la taille du logement de l'ergot d'encliquetage allant en diminuant lorsqu'on va dans le sens opposé au sens d'enfichage.

2. Dispositif de support pour boîtiers, en particulier pour des dispositifs électriques dans des véhicules utilitaires, comportant :
◆ un support (2),
◆ au moins un boîtier (1), qui peut être fixé avec encliquetage, sur le support, par une coopération d'une ou plusieurs paires d'éléments d'encliquetage se présentant sous la forme chaque fois d'un ergot d'encliquetage (14) et d'un logement d'ergot d'encliquetage (15), dont chaque fois un élément se trouve sur le support et l'autre élément sur le boîtier, et
◆ au moins une unité de ressort tendeur (9) sur le boîtier (1) et une butée de ressort tendeur (12), associée à l'unité de ressort tendeur, sur le support (2), où
◆ le boîtier peut être fixé sur le support, en étant assuré dans une direction d'enfichage (S) et à l'encontre de la direction d'enfichage, la sécurité agissant à l'encontre de la direction d'enfichage étant provoquée par la mise en appui, provoquée par la force du ressort tendeur, de l'ergot d'encliquetage (14) sur une bordure (16) du logement d'encliquetage, saisie par l'arrière par celui-ci,
**caractérisé en ce que,**
◆ la sécurité agissant dans la direction d'enfichage (S) de la fixation de boîtier sur le support (2) étant provoquée par la mise en appui de l'unité à ressort tendeur sur la butée de ressort tendeur,
◆ pour désolidariser le boîtier (1) du support (2), l'ergot d'encliquetage est déplaçable de la position saisissant par l'arrière le bord du logement, par un déplacement du boîtier dans la direction d'enfichage, à l'encontre de la force exercée par le ressort tendeur, en une position libérée du logement de l'ergot d'encliquetage et, ensuite, le boîtier est susceptible d'être extrait du logement perpendiculairement à la direction d'enfichage, par un déplacement du boîtier, et
◆ le support (40) contient au moins une plaque de maintien (48), qui présente deux paires, espacées dans la direction d'enfichage (S), de logements (51, 52) pour les ergots d'encliquetage, afin de recevoir au choix l'un des deux boîtiers (45, 46) différents ayant un espacement différent entre les ergots d'encliquetage (14) et la face arrière du boîtier et/ou qui présente des logements d'ergot d'encliquetage (51, 52), qui sont équipés pour recevoir deux ergots d'encliquetage (14) appartenant à des boîtiers (46) pouvant être enfichés sur des côtés opposés de la plaque de maintien, des ergots de butée (47) du ressort tendeur étant formés sur le support, au-dessus et au-dessous de la plaque de maintien.

3. Dispositif de support pour boîtiers selon la revendication 2, en outre caractérisé en ce qu'
◆ au moins l'une faces latérales d'ergot d'encliquetage, opposées transversalement par rapport à la direction d'enfichage (S), et la face de bordure, venant en appui contre celles-ci, du logement d'ergot d'encliquetage étant réalisées en s'étendant sous un angle aigu (α₂) par rapport à la direction d'enfichage, la largeur de l'ergot d'encliquetage et la taille du logement de l'ergot d'encliquetage allant en diminuant en allant dans le sens opposé au sens d'enfichage.

4. Dispositif de support pour boîtiers selon l'une des revendications 1 à 3, en outre caractérisé en ce que l'unité de ressort tendeur (9) est fixée sur une paroi arrière (4) du boîtier et l'ergot d'encliquetage (14) est formé d'un seul tenant sur une paroi avant (5) du boîtier.

5. Dispositif de support pour boîters selon l'une des revendications 1 à 4, en outre caractérisé en ce que :
◆ l'ergot d'encliquetage (34) et l'unité de ressort tendeur (29) sont disposés dans la zone d'un côté étroit (27) du boîtier, pouvant être plaqué contre une paroi support (22) présentant le logement (35) de l'ergot d'encliquetage, et
◆ l'unité de ressort tendeur étant réalisée sous la forme d'une bande élastique pliée, qui est fixée à une extrémité sur le boîtier (21) et qui, à son autre extrémité (30) libre, est pliée en constituant une indentation orientée à l'encontre de la direction d'enfichage (S), indentation dans laquelle la butée (23) du ressort tendeur peut supporter de façon sûre le boîtier, perpendiculairement par rapport au côté étroit (27).

6. Dispositif de support pour boîtiers selon la revendication 5, en outre caractérisé en ce que :
◆ la butée de ressort tendeur (23) est réalisée sous la forme d'une limitation en forme de U ouverte dans la direction d'enfichage (S), dans l'évidement (33) de laquelle peut être introduit le ressort tendeur (29), la taille de l'évidement allant en augmentant en évoluant dans le sens inverse de la direction d'enfichage (S), en ce qu'au moins une face de délimitation (31, 32) afférente s'étend sous un angle aigu (α₃) par rapport à la direction d'enfichage (S).

7. Dispositif de support pour boîtiers selon l'une des revendications 1 à 4, en outre caractérisé par :
◆ des unités de ressort tendeur (9) réalisées sous la forme de chaque fois deux bandes élastiques fixées à un côté sur les zones latérales de la face arrière (4) du boîtier, bandes dont les extrémités libres constituent en appui les unes contre les autres une indentation de ressort tendeur (10) orientée dans le sens opposé à la direction d'enfichage (S), indentation contre laquelle la butée de ressort (12) place en appui de façon sûre le boîtier (1), perpendiculairement à une paroi support (3), où
◆ le boîtier peut être fixé en appui, par un côté large (13), contre la paroi support qui présente le logement pour ergot d'encliquetage (15).

8. Dispositif de support pour boîtiers selon l'une des revendications 1 à 7, en outre caractérisé en ce que le support (40) est réalisé sous la forme d'une pièce de forme monobloc, destinée à fixer avec possibilité d'encliquetage plusieurs boîtiers (44, 45, 46).
